# EUROPEAN PATENT SPECIFICATION

(11) **EP 2 377 211 B1**
(45) Date of publication and mention of the grant of the patent: **20.02.2013**
(21) Application number: 09774975.8
(22) Date of filing: 01.12.2009
(51) Int. Cl.: H01S 5/065, H01S 5/183, H01S 5/42, B41J 2/45, B41J 2/455, G06K 15/12

(54) **HIGH POWER VCSEL WITH IMPROVED SPATIAL MODE**
HOCHLEISTUNGS-VCSEL MIT VERBESSERTEM RÄUMLICHEM MODUS
VCSEL HAUTE PUISSANCE À MODE SPATIAL AMÉLIORÉ

(30) Priority: 10.12.2008 EP 08171181
(43) Date of publication of application: 19.10.2011
(73) Proprietor: Philips Intellectual Property & Standards GmbH, 20099 Hamburg (DE); Koninklijke Philips Electronics N.V., 5621 BA Eindhoven (NL)
(72) Inventor: KOLB, Johanna, S., 5656 AE Eindhoven (NL); MILLER, Michael, 5656 AE Eindhoven (NL); WINTERSTEIN, Sebastian, 5656 AE Eindhoven (NL); ERNST, Uwe, 5656 AE Eindhoven (NL)
(74) Representative: Van Eeuwijk, Alexander Henricus Waltherus
(86) International application number: PCT/IB2009/055437
(87) International publication number: WO 2010/067261

(56) References cited:
- EP-A2- 1 207 599
- EP-A2- 1 317 038
- WO-A2-01/95445
- US-A- 6 121 983
- US-B1- 6 778 582
- US-B2- 6 661 829
- STRZELECKA E M ET AL: "Monolithic integration of vertical-cavity laser diodes with refractive GaAs microlenses" ELECTRONICS LETTERS, IEE STEVENAGE, GB, vol. 31, no. 9, 27 April 1995 (1995-04-27) , pages 724-725, XP006002741 ISSN: 0013-5194

## Description

### FIELD OF THE INVENTION

The present invention relates to a vertical cavity surface emitting laser (VCSEL) comprising an optical gain medium arranged between a first distributed Bragg reflector (DBR) and a second Distributed Bragg Reflector, said first and said second DBR forming a laser cavity and being designed to allow self-contained lasing in said laser cavity and said second DBR being partially transparent for laser radiation resonating in said laser cavity, and an optical element arranged on a side of said second DBR outside of said laser cavity on an optical axis of said laser cavity, said optical element having a concave surface facing said second DBR and being designed to reflect a portion of laser radiation passing through the second DBR back into the laser cavity.

VCSEL devices emitting in the infrared wavelength range are quite common in optical communication applications. The laser cavity of such VCSEL devices consists of two stacks of distributed Bragg reflectors, which are epitaxially grown on a suited substrate and which enclose a gain region made up from several quantum wells. The DBR layers also take over the task of feeding current into the gain region. Therefore one of the DBRs is usually n-doped and the other p-doped. One DBR is designed to be highly reflective for the laser radiation resonating in the laser cavity - typically the p-DBR with a reflectivity of > 99.9 % - , while the other one is partially transparent for the laser radiation allowing efficient outcoupling and thus also feedback into the laser cavity.

A big advantage of VCSELs is due to their surface emitting properties. This allows the production and testing of VCSELs on wafer level in large quantities, which opens the possibility of a low-cost production process. Furthermore the output power of a VCSEL can be scaled to a certain extend via the area of the emitting surface. Larger output powers can be achieved by forming VCSEL arrays.

### BACKGROUND OF THE INVENTION

For achieving higher output powers with a VCSEL, large active areas have to be provided. These large scale VCSELs, however, suffer from emission in higher order spatial modes and in addition from a strong dependency of the spatial mode distribution on the feeding current in the device.

The higher order spatial modes can be ring shaped and therefore do not have any intensity on the symmetry axis. A behavior like that is very critical for applications where the light of the laser diodes has to be focused to a certain small focal point in order to deliver heat or optical power in a controlled way to a small spot on an object. Additionally the strong dependence of the laser mode on the current allows only very selected operating points to maintain a stable emission mode and is therefore not very practical.

A standard method to overcome these difficulties is to reduce the reflectivity of the outcoupling DBR and adding an external mirror to form the laser cavity. Such a modified VCSEL with an external mirror is then called a vertical extended cavity surface emitting laser (VECSEL). It benefits from high output powers and well defined mode profiles of the laser emission. Such lasers can even reach laser emission on a single transverse mode. The reflectivity of the intermediate DBR is reduced such that no laser emission without external feedback will occur. With this reduction of the reflectivity of the intermediate DBR to a value at which the laser does not operate without external optical feedback, the complexity of the system is significantly increased as the additional external mirror has to be aligned with very high precision. The device in combination with the external mirror also has to be carefully mounted and after alignment of the system it has to be fixed for any later application. A characterization of the system on wafer level is not possible for these reasons.

The use of a VECSEL instead of a VCSEL therefore adds complexity to the production process. The very small tolerances in the alignment of the external mirror with respect to the semiconductor device require a sophisticated alignment and production process of single VECSEL diodes and an even more complicated and therefore more expensive alignment process when forming arrays of VECSEL diodes. Therefore a large portion of the unique properties of VCSELs like the wafer scale production and testing is omitted with the addition of the external cavity.

"Monolithic integration of vertical-cavity laser diodes with refractive GaAs microlenses" is disclosed in an article by E. Strzelecka et al., Electronics Letters, vol. 31, No. 9 (1995), pages 724-725.

EP 1 317 038 A2 discloses integration of a VCSEL array and a microlens for optical scanning.

US 6,661,829 B2 describes a VCSEL including a feedback member which reflects a portion of light externally emitted from the laser cavity back into the cavity. The feedback member acts as a concave mirror for the laser resonator. By appropriate design and arrangement of this feedback member the VCSEL operates predominantly in the single fundamental transverse mode. The feedback member may be an inner lens surface of a convex lens structure and is attached to the VCSEL device. The ratio R/d of the radius of curvature R of the reflecting surface of the feedback member and the distance d between the feedback member and the gain medium is in the range between 20 and 50 in this document, calculated on the typical dimensions of a VCSEL structure. The feedback member feeds a portion of the laser radiation externally emitted from the laser cavity back into the resonator and thus influences the lasing behavior, in particular affects the original modes. Such a laser design is suitable for allowing laser oscillation predominantly in the fundamental transverse mode. In order to achieve a high power operation this document proposes to increase at least one of the aperture of oscillation, and the effective diameter and radius of curvature of the feedback member.

### SUMMARY OF THE INVENTION

An object of the present invention is to provide a high power VCSEL device which emits laser radiation with satisfying mode distribution and stability at even higher power levels.

This object is achieved with the VCSEL device of claim 1. Advantageous embodiments of this VCSEL device are subject matter of the dependent claims or are described in the subsequent portions of the specification.

The proposed VCSEL device comprises an optical gain medium arranged between a first DBR and a second DBR, said first and said second DBR forming a laser cavity and being designed to allow self-contained lasing in said laser cavity. The second DBR is partially transparent for laser radiation resonating in the laser cavity. The second DBR thus forms the outcoupling mirror of the laser cavity and still has a sufficiently high coefficient of reflection for the laser radiation to allow self contained-lasing, i.e. lasing without any external optical feedback within the laser cavity defined by the two DBRs. The DBRs and the gain medium may be formed in a known manner from appropriate layer stacks. An optical element is arranged on a side of said second DBR outside of the laser cavity on the optical axis of the laser cavity. The optical element has a concave surface facing said second DBR and is designed to reflect a portion of laser radiation emitted through the second DBR back into the laser cavity. In order to achieve the high power output, the ratio R/d of the radius of curvature R of the concave surface and the distance d between said concave surface and the gain medium is in the range between 1 and 2.

The proposed VCSEL device is based on a common VCSEL with typical indices of reflection of the two DBR's forming the laser cavity in order to allow already self-contained lasing of this VCSEL without any further optical feedback. A weak external optical feedback is added to such a VCSEL design, which reduces the spot size of the fundamental mode in the active area of the device and also reduces the number of emitted transversal modes of the laser. The external feedback is achieved by adding an external optical device having a concave surface with a small reflectivity, namely less than 40%, sufficient to induce some weak external feedback into the laser cavity of the VCSEL. Instead of designing a VECSEL with the reduced reflectivity of the intermediate DBR and a high reflecting external mirror, a low reflecting surface with a reflectivity of approximately 20 to 30 % is sufficient to couple light back into the laser cavity and to introduce some feedback causing a reduction of the spatial mode order. By selecting the distance d of the reflecting surface to the gain medium (the distance being measured on the optical axis) and the radius of curvature R of the reflecting surface such that the ratio R/d is between 1 and 2, a large gain area device is provided which achieves the required spatial mode reduction and stabilization at the same time as a high power output of the laser emission. It has been found that instead of increasing the ratio R/d as proposed in the above document of the prior art, the reduction of this ratio is essential to achieve the above object of the invention. A further advantage of the proposed VCSEL structure is the finding that the optical element can be aligned with large tolerances in order to improve the mode profile as well as the efficiency of the VCSEL device. This is completely different from the high precision necessary for the alignment of an external mirror of a VECSEL and therefore still allows the fabrication and testing of such VCSEL devices on a wafer level.

In one embodiment of the proposed VCSEL device the concave surface facing the second DBR is an inner surface of an optical lens. Such a lens can be used to focus, collimate or diverge the laser beam emitted by the VCSEL device. In order to achieve an appropriate reflection of a portion of the laser radiation back into the laser cavity, the external surface of this lens is preferably coated appropriately.

In a further embodiment, the optical element is directly attached to the VCSEL, for example in case of a forward emitting VCSEL on top of the upper DBR. To this end, the optical element is designed of an optically transparent material, transparent for the wavelength of the laser radiation, and forms on top the reflecting surface being the inner surface of the element, i.e. is convexly shaped to form a concave reflecting inner surface.

In order to achieve a sufficiently large feedback region inside of the laser cavity for high power output, the distance between the reflecting surface and the gain medium should be high enough to allow a sufficiently large radius of curvature of the reflecting surface. Preferably, the distance between the reflecting surface and the gain medium is ≥ 1 mm, typically between 1 and 4 mm and preferably between 1.5 and 3.0 mm.

For many applications several of the proposed VCSEL devices are arranged side by side on a common substrate to form a VCSEL array. These VCSEL arrays can be used, for example, for heating or drying applications, for rapid thermal processing or for food processing. A further important application is in the technical field of printing. In this field the VCSEL array is preferably used for generating images (to be printed only once or in a preferred manner a plurality of times) with laser radiation, in particular for imaging, recording or writing printing forms such as printing plates or printing surfaces of cylinders. The VCSEL array may be integrated in a printing substrate processing apparatus, in particular a printing machine, or in a printing form processing apparatus, in particular a platesetter. Examples for such machines or apparatuses can be found in Kipphan, Handbook of Print Media, Springer-Verlag, Berlin, 2001, chapter 4.3 (Computer to Plate/to Cylinder/to Screen) and chapter 4.4 (Computer to Press/Direct Imaging). In a preferred embodiment the machine is a lithographic offset printing machine processing sheets and the VCSEL arrays are used in the printing machine to image lithographic printing plates mounted on printing form cylinders of the machine. In another preferred embodiment the machine is an imaging apparatus separate from a printing machine and the VCSEL arrays are used in the imaging apparatus to image lithographic printing plates mounted on an imaging cylinder of the apparatus.

These and other aspects of the invention will be apparent from and elucidated with reference to the embodiments described herein after.

### BRIEF DESCRIPTION OF THE DRAWINGS

The following exemplary embodiments show examples of the proposed VCSEL device with reference to the accompanying figures without limiting the scope of protection as defined by the claims. The figures show:
- Fig. 1: a schematic view of a first embodiment of a device according to the present invention;
- Fig. 2: a schematic view of a second embodiment of a device according to the present invention; and
- Fig. 3: a schematic view of an exemplary array of devices according to the present invention.

### DETAILED DESCRIPTION OF EMBODIMENTS

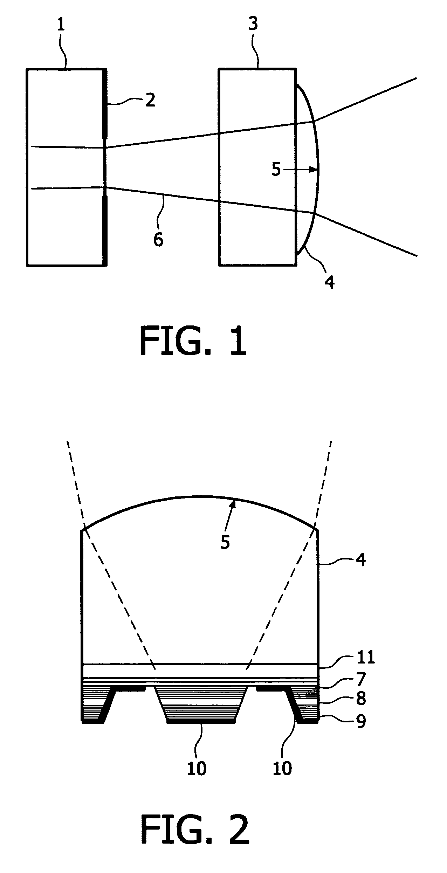

Figure 1 shows a schematic view of a first example of the proposed VCSEL device. In this embodiment the weak feedback is realized by a curved mirror placed apart from the VCSEL 1, which is only indicated schematically in figure 1. A confinement layer 2 on the upper DBR of VCSEL 1 forms an aperture for the emitted laser radiation, the laser beam 6 being indicated in the figure. The optical element forming the reflecting surface for feedback is a coated micro lens 4 in this example. The coating may be a stack of appropriate dielectric layers like Ta₂O₅ and SiO₂ similar materials. This micro lens 4 is attached to a glass block 3 having a thickness of 200 µm. The air gap between the VCSEL 1 and this glass block 3 is 3 mm. The micro lens is coated to have a reflectivity of the inner surface 5 of 30% for the laser radiation, such that 30% of the laser radiation emitted by the VCSEL 1 is fed back into the laser cavity. This improves and stabilizes the spatial mode profile inside of the VCSEL. The radius of curvature of the inner reflecting surface 5 is 3.3mm.

With such a device, for example with a diameter of the active area of 80 µm, the spatial mode of the VCSEL in the far field of the laser emission changes from a ring shaped higher order mode without intensity on the symmetry axis to a mode with maximum intensity concentrated on the symmetry axis. The spatial mode distribution is not single mode but sufficient for most applications where the light has to be delivered to a small focal point. Surprisingly, the alignment of the external optical element, i.e. the glass block 3 with the micro lens 4, is not very critical, other than expected from literature and common knowledge in the field of vertical extended cavity surface emitting lasers (VECSEL), where the output power and spatial mode profile are very critically dependent of the alignment of the external mirror such that the tolerances for the alignment are very small. Contrary to this, for the alignment of the proposed low reflecting feedback low cost standard tools and cameras can be used which simplifies the alignment process significantly. For a VCSEL device with a diameter of the active area of 80 µm, the optimal spatial mode reduction is achieved within an alignment tolerance of ± 50 µm displacement (in vertical and horizontal direction) of a coated micro lens in front of the device.

Another advantage of such a VCSEL device is the use of standard designs for VCSEL structures without the need of a redesign of the structure for adoption to the proposed VCSEL concept. It is then possible to change the mode profile of finished VCSELs just by adding the small external reflectivity, i.e. the appropriate optical element. The additional reflectivity introduced into the laser beam, which reflects part of it back into the VCSEL structure, i.e. into the laser cavity, does not affect the intensity of the laser output significantly. It even improves the performance partly as it reduces the threshold current and shifts the thermal roll-over to higher currents. The spatial mode of the laser emission is stabilized over the complete operation region of the VCSEL device up to the thermal roll-over.

By using the ray matrix method for calculating resonators of lasers and comparing with experimental results guidelines for the design of the feedback can be extracted. This process can help to design the actual parameters of the feedback, as the theory for stable resonators still applies although the external feed back is very weak. A comparison of the mode waists of the laser beam calculated with the ray matrix method with experimental results of spatial mode measurements with weak feedback leads to the conclusion that a certain mode waist (depending on the actual parameters of the device) is correlated with an optimized and stable mode with low order and all intensity centered on the symmetry axis. This model can therefore be used to predict the resonator design for the external feedback such as optimal distances and the radius of curvature of the optical reflector, the ratio R/d of which must be chosen between 1 and 2.

From the above it is obvious that the design of the VCSEL itself, i.e. without the external optical element, can be chosen in the same manner as already known in the art. For this reason, examples for such designs are not described in the present patent application since they are common knowledge of the skilled person in this field.

Another benefit from the solution of the problem of mode improvement and stabilization while allowing a high output power output is the possibility to design the low reflecting optical element in a way such that this element can be mounted, e.g. glued or bonded directly on the emitting surface of the VCSEL or even of a VCSEL array to form a hybrid package. To this end, the micro lens for mounting on top of the laser is preferably of a planar-convex type with the flat side positioned against the VCSEL structure for a very simple mounting. An example of such a device is schematically depicted in figure 2. This figure shows a typical VCSEL design based on the lower DBR, 9 the gain medium 8 and the upper DBR 7 as well as the electrical contacts 10 and a layer structure 11 including the substrate on which the VCSEL structure is grown. This is a so called backside or bottom emitting VCSEL which emits the laser radiation through the for the wavelength transparent substrate. On top of this layer structure 11 the planar-concave micro lens 4 is attached. The upper inner surface 5 of this micro lens 4 forms the concave reflecting surface for the weak feedback. The dashed lines indicate the light cone of the laser emission. In the embodiment of figure 2, the distance between the concave reflecting surface 5 and the gain medium 8 is chosen to be approximately 2 mm, whereas the radius of curvature of the micro lens, i.e. of the concave reflecting surface 5, is chosen to be 2.3 mm.

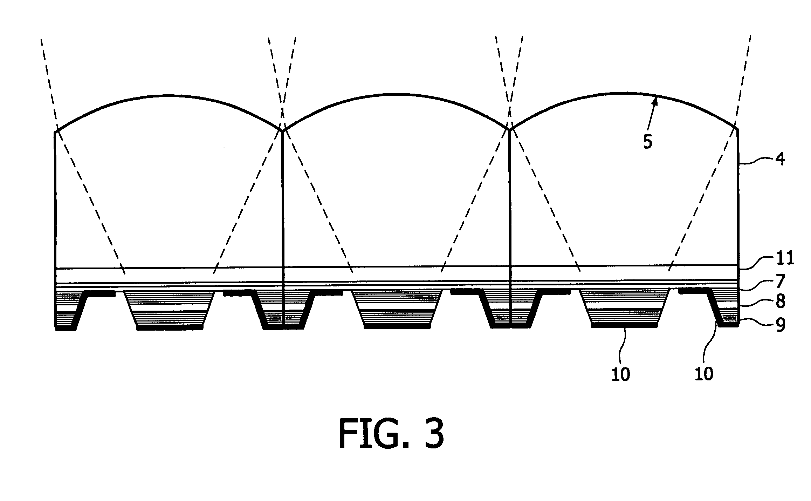

Such a device can be formed on wafer level in order to achieve an array of VCSEL devices with the coated micro lens structure on top. Such an array of VCSEL devices is exemplary shown in figure 3.

In the claims, the word "comprising" does not exclude other elements or steps, and the indefinite article "a" or "an" does not exclude a plurality. The mere fact that measures are recited in mutually different dependent claims does not indicate that a combination of these measures can not be used to advantage. For example, the external element is not limited to the use of a lens but can also consist for example of a concave mirror spaced a part from the VCSEL. The reference signs in the claims should not be construed has limiting the scope of these claims.

### LIST OF REFERENCE SIGNS

- 1: VCSEL
- 2: confinement layer
- 3: glass block
- 4: micro lens
- 5: inner reflecting surface
- 6: laser beam
- 7: upper DBR
- 8: gain medium
- 9: lower DBR
- 10: electrical contacts
- 11: layer structure

## Claims

1. A VCSEL device comprising
- an optical gain medium (8) arranged between a first DBR (9) and a second DBR (7),
- - said first and said second DBR (7,9) forming a laser cavity and being designed to allow self-contained lasing in said laser cavity and
- - said second DBR (7) being partially transparent for laser radiation resonating in said laser cavity, and
- an optical element arranged on a side of said second DBR (7) outside of said laser cavity on an optical axis of said laser cavity,
- - said optical element having a concave surface (5) facing said second DBR (7) and being designed to reflect a portion of laser radiation emitted through the second DBR (7) back into the laser cavity,
- wherein a ratio R/d of a radius of curvature R of said concave surface (5) and a distance d between said concave surface (5) and said gain medium (8) is in the range between 1 and 2, **characterised in that**
the optical element having a reflectivity of less than 40% adds sufficient optical feedback to the laser cavity such that a spot size of a fundamental mode in the optical gain medium (8) of the VCSEL device and the number of transversal modes of the VCSEL device are reduced.

2. The VCSEL device according to claim 1,
wherein said concave surface (5) facing said second DBR (7) has a reflectivity of between 20% and 30% for the laser radiation.

3. The VCSEL device according to claim 1 or 2,
wherein said concave surface (5) facing said second DBR (7) is an inner surface of a micro lens (4).

4. The VCSEL device according to claim 3,
wherein said micro lens (4) is a plano-convex lens.

5. The VCSEL device according to claim 1 or 2,
wherein said concave surface (5) facing said second DBR (7) is an inner surface of an optical element mounted on said second DBR (7).

6. The VCSEL device according to claim 1,
wherein said distance between said concave surface (5) and said gain medium (8) is ≥ 1 mm.

7. A VCSEL array comprising several VCSEL devices according to one of claims 1 to 6 on a common substrate (11).

8. A device for generating images, in particular for imaging printing forms, with laser radiation, said device comprising at least one VCSEL array according to claim 7.

9. The use of a VCSEL array according to claim 7 for generating images, in particular for imaging printing forms, with laser radiation.

10. Printing substrate processing apparatus, in particular printing machine, comprising at least one device according to claim 8.

11. Printing form processing apparatus, in particular platesetter, comprising at least one device according to claim 8.

## Patentansprüche

1. Hochleistungs-VCSEL-Vorrichtung mit:
- einem zwischen einem ersten DBR (9) und einem zweiten DBR (7) angeordneten, optischen Verstärkungsmedium (8),
- wobei der erste und der zweite DBR (7,9) eine Laserkavität bilden und so ausgeführt sind, dass sie ein selbstständiges Lasern in der Laserkavität ermöglichen, und
- der zweite DBR (7) für in der Laserkavität schwingende Laserstrahlung teilweise durchlässig ist; sowie
- einem optischen Element, das auf einer Seite des zweiten DBR (7) außerhalb der Laserkavität auf einer optischen Achse der Laserkavität angeordnet ist,
- wobei das optische Element eine dem zweiten DBR (7) zugewandte, konkave Oberfläche (5) aufweist und so ausgeführt ist, dass es einen Teil der durch den zweiten DBR (7) emittierten Laserstrahlung in die Laserkavität zurück reflektiert,
- wobei ein Verhältnis R/d eines Krümmungsradius R der konkaven Oberfläche (5) und eines Abstands d zwischen der konkaven Oberfläche (5) und dem Verstärkungsmedium (8) im Bereich zwischen 1 und 2 liegt, **dadurch gekennzeichnet, dass** das optische Element mit einer Reflektivität von weniger als 40% die Laserkavität mit ausreichender optischer Rückkopplung versieht, so dass eine Spotgröße einer Grundwelle in dem optischen Verstärkungsmedium (8) der VCSEL-Vorrichtung und die Anzahl von Transversalwellen der VCSEL-Vorrichtung reduziert werden.

2. VCSEL-Vorrichtung nach Anspruch 1,
wobei die dem zweiten DBR (7) zugewandte, konkave Oberfläche (5) eine Reflektivität zwischen 20% und 30% für die Laserstrahlung aufweist.

3. VCSEL-Vorrichtung nach Anspruch 1 oder 2,
wobei die dem zweiten DBR (7) zugewandte, konkave Oberfläche (5) eine Innenfläche einer Mikrolinse (4) ist.

4. VCSEL-Vorrichtung nach Anspruch 3,
wobei die Mikrolinse (4) eine plankonvexe Linse ist.

5. VCSEL-Vorrichtung nach Anspruch 1 oder 2,
wobei die dem zweiten DBR (7) zugewandte, konkave Oberfläche (5) eine Innenfläche eines auf dem zweiten DBR (7) angebrachten, optischen Elements ist.

6. VCSEL-Vorrichtung nach Anspruch 1,
wobei der Abstand zwischen der konkaven Oberfläche (5) und dem Verstärkungsmedium (8) ≥ 1 mm beträgt.

7. VCSEL-Array mit mehreren VCSEL-Vorrichtungen nach einem der Ansprüche 1 bis 6 auf einem gemeinsamen Substrat (11).

8. Vorrichtung zur Erzeugung von Bildern, genauer gesagt, zur Bildgebung von Druckformen, mittels Laserstrahlung, wobei die Vorrichtung mindestens ein VCSEL-Array nach Anspruch 7 umfasst.

9. Verwendung eines VCSEL-Arrays nach Anspruch 7 zur Erzeugung von Bildern, genauer gesagt, zur Bildgebung von Druckformen, mittels Laserstrahlung.

10. Drucksubstratbearbeitungsvorrichtung, genauer gesagt, Druckmaschine, mit mindestens einer Vorrichtung nach Anspruch 8.

11. Druckformbearbeitungsvorrichtung, genauer gesagt, Plattenbelichter, mit mindestens einer Vorrichtung nach Anspruch 8.

## Revendications

1. Dispositif laser à cavité verticale émettant par la surface (VCSEL) comprenant :
- un milieu de gain optique (8) agencé entre un premier réflecteur de Bragg distribué (DBR) (9) et un second DBR (7),
- lesdits premier et seconds DBR (7, 9) formant une cavité laser et étant conçus pour permettre une émission laser autonome dans ladite cavité laser, et
- ledit second DBR (7) étant partiellement transparent à un rayonnement laser résonnant dans la cavité laser, et
- un élément optique agencé sur un côté dudit second DBR (7) à l'extérieur de ladite cavité laser sur un axe optique de ladite cavité laser,
- ledit élément optique présentant une surface concave (5) faisant face au second DBR (7) et étant conçue pour réfléchir une partie du rayonnement laser émis à travers le second DBR (7) vers l'arrière dans la cavité laser,
- dans lequel un rapport R/d d'un rayon de courbure R de ladite surface concave (5) sur une distance d entre ladite surface concave (5) et ledit milieu de gain (8) est compris entre 1 et 2, **caractérisé en ce que** l'élément optique ayant une réflectivité inférieure à 40 % ajoute une rétroaction optique suffisante à la cavité laser de sorte qu'une taille de spot d'un mode fondamental dans le milieu de gain optique (8) du dispositif VCSEL et le nombre de modes transversaux du dispositif VCSEL soient réduits.

2. Dispositif VCSEL selon la revendication 1,
dans lequel ladite surface concave (5) faisant face au dit second DBR (7) a une réflectivité comprise entre 20 % et 30 % pour le rayonnement laser.

3. Dispositif VCSEL selon la revendication 1 ou 2,
dans lequel ladite surface concave (5) faisant face au dit second DBR (7) est une surface intérieure d'une microlentille (4).

4. Dispositif VCSEL selon la revendication 3,
dans lequel ladite microlentille (4) est une lentille plan-convexe.

5. Dispositif VCSEL selon la revendication 1 ou 2,
dans lequel ladite surface concave (5) faisant face au dit second DBR (7) est une surface intérieure d'un élément optique monté sur ledit second DBR (7).

6. Dispositif VCSEL selon la revendication 1,
dans lequel ladite distance entre ladite surface concave (5) et ledit milieu de gain (8) est inférieure ou égale à 1 mm.

7. Réseau VCSEL comprenant plusieurs dispositifs VCSEL selon l'une quelconque des revendications 1 à 6 sur un substrat commun (11).

8. Dispositif pour générer des images, en particulier pour imager des formes d'impression, avec un rayonnement laser, ledit dispositif comprenant au moins un réseau VCSEL selon la revendication 7.

9. Utilisation d'un réseau VCSEL selon la revendication 7 pour générer des images, en particulier pour imager des formes d'impression, avec un rayonnement laser.

10. Appareil de traitement de substrat d'impression, en particulier machine d'impression, comprenant au moins un dispositif selon la revendication 8.

11. Appareil de traitement de forme d'impression, en particulier dispositif d'exposition, comprenant au moins un dispositif selon la revendication 8.
